# EUROPEAN PATENT SPECIFICATION

(11) **EP 1 663 720 B1**
(45) Date of publication and mention of the grant of the patent: **29.06.2011**
(21) Application number: 04778667.8
(22) Date of filing: 19.07.2004
(51) Int. Cl.: B60R 16/02, B60R 21/00

(54) **VEHICLE TOUCH INPUT DEVICE**
FAHRZEUGBERÜHRUNGSEINGABEVORRICHTUNG
DISPOSITIF D'ENTREE TACTILE POUR VEHICULE ET SES PROCEDES DE FABRICATION

(30) Priority: 08.09.2003 US 658490
(43) Date of publication of application: 07.06.2006
(73) Proprietor: 3M Innovative Properties Company, St. Paul, MN 55133-3427 (US)
(72) Inventor: HAGERMOSER, Scott E., 3M Center, Saint Paul, MN 55133-3427 (US); ROBRECHT, Michael J., 3M Center, Saint Paul, MN 55133-3427 (US)
(74) Representative: Vossius & Partner
(86) International application number: PCT/US2004/023261
(87) International publication number: WO 2005/025942

(56) References cited:
- WO-A1-99/52761
- US-A- 5 423 569
- US-A- 5 520 412
- US-A- 5 942 815
- US-A- 6 042 142
- US-A1- 2004 158 374
- US-B1- 6 273 461
- PATENT ABSTRACTS OF JAPAN vol. 2003, no. 03, 5 May 2003 (2003-05-05) & JP 2002 326554 A (FUJIKURA LTD), 12 November 2002 (2002-11-12)

## Description

This invention relates to touch input devices. In particular, the invention relates to touch input devices that may be incorporated into or disposed behind various surfaces accessible to an occupant of a vehicle, according to the preamble of claim 1 and as it is disclosed in US 5 942 815 A.

### Background

Touch sensors have become an increasingly common way for users to intuitively interact with electronic systems, typically those that include displays for viewing information. Touch sensors include transparent touch panels that can be disposed over a display so that the display can be viewed through it. Touch sensors also include touch pads that are positioned off a display, for example mouse pads such as those found on many laptop computers.

Information displays are becoming more and more prevalent in cars and other vehicles. Heads up displays, navigation systems, entertainment systems, and the more conventional radio and dashboard displays are just some examples. Providing controls to interact with these various displays and other electronic systems in the vehicle can pose significant challenges. A convenient location to place controls in an automobile for access by the driver can be on the steering wheel. However, usable space on the steering wheel can be limited, especially when considering the presence of an airbag.

### Summary of the Invention

The present invention provides a touch input device for interacting with electronic systems in a vehicle that includes an airbag, as defined according to claim 1. The device includes an airbag cover having a surface accessible to and touchable by an occupant of the vehicle, and a capacitive touch sensor disposed between the airbag and the airbag cover, the touch sensor configured so that a touch to a designated area of the surface allows capacitive coupling between the touch and the touch sensor through the airbag cover. The touch sensor is disposed in a manner such that the presence of the touch sensor maintains the look, feel, and functionality of the surface as if the touch sensor was excluded. The touch sensor is adapted for connecting to a controller capable of using signals generated by the capacitive coupling to interact with electronic systems of the vehicle.

A method of making a touch-enabled airbag cover includes providing an airbag cover configured for enclosing an airbag in a vehicle and for providing a finished surface, and disposing a capacitive touch sensor on a back surface of the airbag cover opposing the finished surface, the touch sensor configured so that a touch to a designated area of the finished surface allows capacitive coupling between the touch and the touch sensor through the airbag cover, the touch sensor adapted for connecting to a controller capable of using signals generated by the capacitive coupling to interact with electronic systems of the vehicle.

The above summary of the present invention is not intended to describe each disclosed embodiment or every implementation of the present invention. The Figures and the detailed description that follow more particularly exemplify these embodiments.

### Brief Description of the Drawings

The invention may be more completely understood in consideration of the following detailed description of various embodiments of the invention in connection with the accompanying drawings, in which:
Figure 1 schematically shows a touch sensor disposed behind a surface in a vehicle;
Figure 2A schematically shows a steering wheel having an airbag cover and incorporating touch sensors;
Figure 2B schematically shows a cross-sectional view of the steering wheel depicted in Figure 2A;
Figure 3A schematically shows a portion of a dashboard incorporating touch sensors;
Figure 3B schematically shows an armrest in a vehicle incorporating a touch sensor;
Figure 4A schematically shows a portion of a surface having a designated area identified by a relief pattern, the designated area indicating the position of a touch sensor disposed under the surface;
Figure 4B schematically shows a side view of the surface shown in Figure 4A taken along line B-B;
Figure 5A schematically shows a portion of a surface having a designated area identified by a relief pattern, the designated area indicating the position of a touch sensor disposed under the surface; and
Figure 5B schematically shows a side view of the surface shown in Figure 5A taken along line B-B.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the spirit and scope of the invention.

### Detailed Description

The present invention relates to the use of capacitive touch sensors activatable by touching a vehicle surface accessible to an occupant in order to control or otherwise interact with various electronic systems in the vehicle that includes an airbag. Disposing one or more touch sensors under one or more surfaces in a vehicle can be a convenient way to allow control of multiple functions in the vehicle without using excessive space or requiring significant reconfiguration of the space in the vehicle as currently used. Touch sensors of the present invention can be made using materials as varied as paper, plastic and cloth depending on the desired attributes. Using such flexible materials as touch sensor substrates can allow the touch sensor to take on almost any shape, size, or contour to meet the needs of the final application. In a particular embodiment, the present invention provides a touch sensor constructed using a woven or non-woven fabric that may be particularly suited for use in areas where it is desirable for the touch surface to remain soft or pliant to the touch.

Methods of constructing and attaching touch sensors to the vehicle touch surfaces include adhering or laminating the touch sensor to the under side of the touch surface, molding the sensor into injection molded parts, constructing the sensor directly on or into the object that provides the touch surface, and other such methods. Capacitive touch sensors can be disposed behind or incorporated into the surface of an airbag cover, a steering wheel, a dashboard, a seat armrest, a center console or any other suitable surface of an automobile or other vehicle for use in interacting with the electronics systems.

As automotive telematics systems become more prevalent, and as more systems combine multiple information displays, a more convenient way of interacting with the information being displayed will be needed. For safety and stylistic reasons, automotive designers may choose to utilize touch input devices other than on-display touch system (i.e., a touch panel disposed over a display so that the display can be viewed through the touch panel).

Off-display touch systems require a certain amount of "real estate" within the vehicle to be dedicated to the touch function. This real estate may be on one of the surfaces of the dashboard, as is traditional, or it could be placed in a number of other locations within the automobile such as between the driver and passenger seats, in the arm rests, in the seats, on the dashboard brow, in a visor, on one of the door panels, or the like. Desirably, the touch function may be within an easy arm's reach of the driver, though some interfaces may be shared between driver and passenger, and some interfaces may be dedicated to passengers and not available to the driver. Advantageously, the present invention provides off-display capacitive touch sensors that can be embedded in or otherwise disposed behind surfaces that are currently provided in automobile or other vehicle interiors so that touching designated areas of such surfaces can activate the touch function. In addition, the present invention can provide such touch sensors in such a way so that current uses of those surfaces are not disrupted. According to the present invention, a touch sensor is embedded in, or printed on, or laminated to the back of an airbag cover without disrupting the safe split apart function of the airbag cover upon airbag deployment. Touch sensors also can be disposed behind surfaces as varied as dashboards, steering wheels, seat covers, arm rests, and the like that incorporate materials as varied as plastics, leather, cloth, and the like without disturbing the desired look and feel of such objects and materials.

In automobiles, a preferred implementation of a general control input system includes placing at least some controls on the steering wheel for easy access by the driver. Currently, traditional button devices are provided on the steering wheel of many automobiles (e.g., for cruise control, radio controls, etc:). Such devices tend to be single function devices in that each button performs one task. For example, the stereo volume control on the steering wheel performs only the volume control function, and it cannot be placed in a different state where it might control some other function such as the fan speed of the HVAC system. Generally, these single function buttons are molded from hard plastic within easy reach of the driver's hand while grasping the steering wheel. Molded buttons can be expensive in that they require engineering resources to design, tools to be made, and wiring harnesses to be accommodated. This interaction model also provides very limited expandability and design flexibility because the only way to add more functionality to the steering wheel is to add more molded buttons to the wheel.

The airbag and the airbag cover take up the bulk of the space on a steering wheel. The replaceable airbag unit is hidden by a cover typically constructed of molded pliable plastic, or plastic covered with leather, which can either split apart in one of several patterns or fly up out of the way as a single panel (though remaining attached to the wheel when the air bag is deployed). Currently, the surfaces of the airbag cover are not used for any type of input device other than as part of the horn system due to the difficulty of putting any physical structures between the airbag unit and the cover itself that will not interfere with the deployment of the airbag. Additionally, any device adhered to the airbag cover has the possibility of being projected toward the driver or passenger during the airbags deployment, which is a safety concern. The present invention provides a way to include a touch sensor for interacting with displayed information and controls systems in a vehicle in a manner that provides flexibility of design, expandability of function, and use of real estate without disrupting current functions and while maintaining safety.

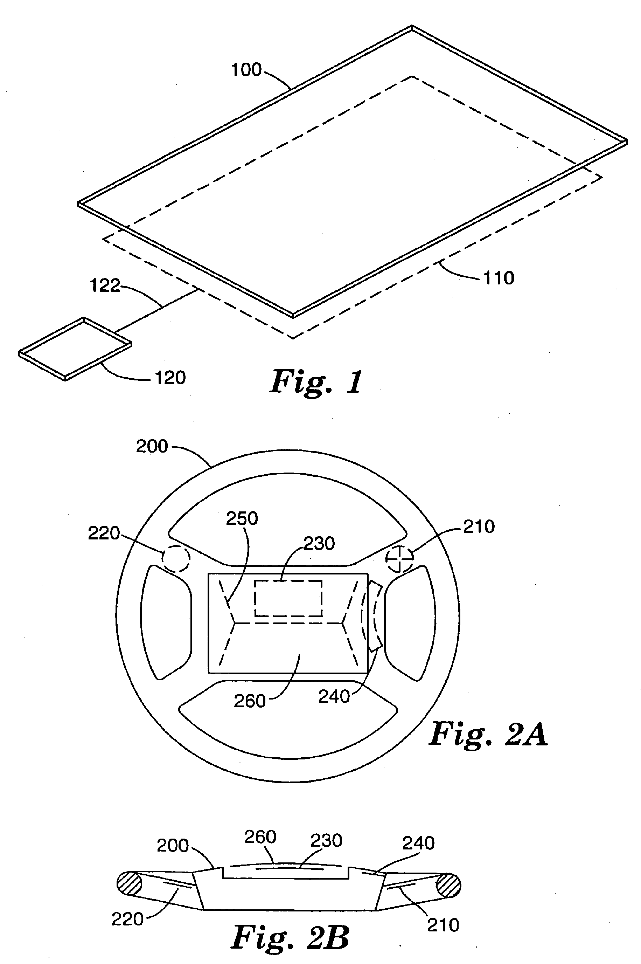

Figure 1 shows a portion of a surface 100 that is accessible to an occupant of a vehicle. Occupants can include drivers and pilots as well as passengers. Vehicles can include automobiles, airplanes, trains, boats, and the like. The surface 100 may be the surface of an airbag cover, the surface of a steering wheel, the surface of a dashboard, the surface of a center console or armrest, the surface of a seat or ceiling liner, or the like. A touch sensor 110 is disposed behind the surface 100 such that a touch to surface 100 in a designated area can activate the touch sensor 110. Activating the touch sensor 110 can generate signals that can be used by controller electronics 120 to communicate information related to the touch input to electronic systems of the vehicle. Touch sensor 110 can be connected to controller 120 using a wiring harness 122 or any such suitable electrical connector.

Touch sensor 110 can be a capacitive touch sensor capable of being activated by capacitively coupling with a conductive touch object such as a user's finger. Because the touch is applied to surface 100, the touch sensor can be configured to capacitively couple with the applied touch through surface 100 and any other layers or materials disposed between surface 100 and touch sensor 110. For.example, when surface 100 is the surface of an airbag cover, touch sensor 110 can be disposed on the back surface of the airbag cover to capacitively couple with applied touches through the thickness of the airbag cover. Capacitive touch sensors capable of detecting touches through relatively thick dielectric layers are known as projected capacitive touch sensors. Exemplary capacitive touch sensors that may be useful in the present invention for sensing touches through a surface accessible to an occupant of a vehicle include those disclosed in U.S. Patent Nos. 4,103,252; 4,659,874; 4,755,634; 4,778,951; 4,999,462; 5,386,219; 5,650,597; 5,844,506; 6,188,391; 6,297,811; and 6,492,979, and International Publications WO 92/08947, WO 96/15464, WO 01/27868, WO 01/52416, and WO 02/100074, which are all wholly incorporated into this document.

In exemplary embodiments, one or more touch sensors can be incorporated into a steering wheel so that a touch to a designated portion of the steering wheel, such as an included airbag cover, can be used to interact with electronic systems in the vehicle. Figure 2A shows an example of a steering wheel 200 that includes an airbag cover 260 and incorporates various touch sensors including discrete button sensor 220 positioned on one of the spokes of the steering wheel, quadrant segmented rocker pad sensor 210 positioned on another of the spokes of the steering wheel, x-y sensor pad 230 positioned behind airbag cover 260, and scroll bar sensor 240 shown to be partially covered by airbag cover 260. Each of touch sensors 210, 220, 230, and 240 have active areas defining where a touch can be applied to the surface of the steering wheel and/or airbag cover to activate the respective touch sensor. These active areas can be designated by graphics, relief patterns, or otherwise to give the user visual and/or tactile indicia for locating the sensors, for indicating the function(s) controlled by the sensors, or for indicating how to use the sensors.

As shown in Figures 2A and 2B, discrete button sensor 220 is positioned on a spoke of the steering wheel and underneath the outer surface of the steering wheel. Discrete button sensor 220 is located for convenient access without requiring the driver to remove his or her hands from the steering wheel. Button sensor 220 measures the capacitive coupling with a conductive touch object, such as the driver's finger or thumb, as it approaches the designated portion of the surface of the steering wheel. As with other capacitive sensors, capacitive coupling can be measured by measuring current that flows through the completed circuit that includes the conductive touch implement and the conductive sensing elements of the sensor. At a predetermined or calibrated level of capacitive coupling, the button can be considered "pressed," allowing a "button down" signal to be sent. When the measured capacitive coupling falls below the threshold, a "button up" signal can be sent. In this way, a user can interact with the button sensor in a manner analogous to interaction with a mechanical button. A discrete button sensor can use any suitable conductor as its sensing element, such as a conductive foil covering the designated area, a conductive ink or other such material printed or coated to cover the designated area, a series of wires or conductive traces disposed to cover the designated area, or the like. Exemplary sensors that can be used as discrete button sensors in the present invention include those disclosed in International Publication WO 96/15464.

As shown in Figures 2A and 2B, a quadrant segmented sensor 210 can be positioned on a spoke of the steering wheel and disposed under the exterior surface of the steering wheel. As with discrete button 220, segmented sensor 210 can be located for easy access by the driver's thumb, for example, without requiring removing a grasp of the steering wheel. As shown, quadrant segmented sensor 210 utilizes four discrete conductive elements shaped as quarter circles within one circular-shaped sensor. By placing a finger or thumb in the designated area over sensor 210, the action of rocking the finger or thumb in any direction results in a change in capacitive coupling in at least one of the segments. This change can be measured to determine the direction and magnitude of the movement, which in turn can be translated into cursor movement or other instructions to a display or other electronic equipment in the vehicle. Exemplary quadrant segmented sensors include those disclosed in U.S. Patent No. 4,755,634.

As shown in Figures 2A and 2B, x-y sensor pad 230 can be centrally located on the steering wheel, for example under an airbag cover 260. Airbag cover 260 is configured to split apart upon deployment of the airbag, for example along break lines 250. Although x-y sensor pad 230 is shown to be entirely contained between break lines, sensors can also be disposed to overlap break lines. In such a case, the sensor can be adapted to split along the overlapped break lines, as is described in further detail in discussions that follow.

Suitable x-y sensor pads include x-y grid sensor pads. X-y grid sensors can include two sets of mutually orthogonal conductive lines, for example sets of conductive lines that are horizontal and vertical with respect to the user. By monitoring capacitive coupling, it can be determined which conductive lines are closest to the applied touch, thus giving location of the touch within the designated area. Interpolation methods can be used to further refine touch location determination. The conductive lines can be wires, conductive traces, or the like. Exemplary x-y grid sensors include those disclosed in U.S. Patent Nos. 6,188,391; 5,844,506; and 5,386,219, as well as International Publications WO 01/27868, WO 02/100074, and WO 01/52416.

Near Field Imaging sensors such as disclosed in U.S. Pat. No. 5,650,597 can also be used as x-y sensor pads. Near Field Imaging sensors can utilize a series of parallel sensor bars. Touch position in one direction can be determined by measuring which bars are experiencing the strongest capacitive coupling. Touch position in the other direction can be determined using ratio metric techniques that compare the current flowing through each end of a sensor bar to detect touch position along that bar. Other projected capacitive sensors capable of determining x-y touch position can be used, such as those disclosed in U.S. Patent Nos. 6,297,811 and 6,492,979.

Referring back to Figures 2A and 2B, scroll bar sensor 240 can be positioned in a convenient location of the steering wheel, for example to one side in the hub of the steering wheel. As indicated in Figure 2A, sensor 240 may be positioned so that it is disposed partially under the airbag cover 260 and partially under the outer surface of the steering wheel adjacent to the airbag cover. Other arrangements are also possible; including positioning sensor 240 entirely under the airbag cover 260, or entirely under a surface of the steering wheel outside of the airbag cover area.

Scroll bar sensor 240 can be constructed as an analog slider sensor or as a set of suitably arranged discrete sensor pads. There are several constructions possible for analog slider sensors depending on desired attributes and decoding electronics. An analog slider sensor measures the movement of a touch input from one end of the sensor to another. This can be achieved by measuring the ratio metric change in resistance from one end of the sensor to the other, for example as is disclosed for determining the touch position along an individual conductive bar in a Near Field Imaging touch sensor as disclosed in U.S. Pat. No. 5,650,597. This can also be achieved by measuring the capacitive effect on each of two nested, elongated triangular sensor elements, for example a single pair of the triangular sensor bars used in the touch sensors disclosed in U.S. Patent Nos. 4,659,874 and 4,999,462. In such an arrangement where the apex of each triangle extends to the base of the other, a change in the ratio of capacitive coupling to each triangle as a touch slides across the long axis of the sensor indicates the direction of the slide. Touch position can also be determined from this information.

A scroll bar sensor can also be constructed as a combination of multiple discrete sensors arranged in close proximity in a linear array, along an arc, or in any other desired path. As a touch input is swiped along the path of the discrete sensors, a series of touch down and lift off events occur successively for each of the discrete sensors in the swipe path. The direction that these touch events are occurring along the path gives the direction of the movement, and the rate at which successive events occur gives an indication of the speed of the swipe movement. Such information can be used to control the scrolling of information on a display, the volume of a radio or speaker phone, the temperature setting of a heating/cooling system, the speed of a blower fan, the position of an occupant's seat, the radio channel frequency, or the like. For example, the direction of swipe can be used to control up or down adjustments, and the speed of swipe can be used for faster and slower scrolling, or for coarse and fine control. Exemplary sensors that can be used as a multiple discrete sensor scroll bar include those disclosed in U.S. Pat. Nos. 5,650,597 and 4,755,634.

These and other various sensor types, along with their sensing elements, can be constructed to have any desired shape or size for inclusion in a vehicle, and can be constructed of various materials that allow the sensors to be conformed to any desired contour.

Sensors suitable for use in the present invention can be constructed from a wide variety of materials selected for attributes desired in the final application. Conventionally, capacitive sensors are constructed by disposing the conductive sensing element(s) on an electrically insulating substrate. The substrate can provide mechanical support, and depending on configuration, capacitive coupling with a touch implement can occur through the substrate with the substrate or some additional layer or material providing the touch surface, or through one or more other layers disposed on the side of the conductive sensing element(s) opposing the substrate that provide the touch surface.

The sensor substrate can be constructed of any suitable non-conductive material. Flexible materials may be well suited in embodiments where the touch sensors are incorporated into objects that include some amount of surface curvature, as are often encountered in vehicle surfaces such as steering wheels, airbag covers, dashboards, and so forth. Using flexible substrate materials can allow the sensors to be conformed to a curved surface. When the touch sensors of the present invention are configured and arranged to be sensed through an airbag cover, it may be desirable to use substrate materials that can be easily split or blown apart upon deployment of the airbag without producing unsafe projectiles. Perforations in or scoring of the substrate or other elements of the touch sensor can be used to aid this process. Exemplary substrate materials that may fulfill one or more of these attributes include paper, cloth, plastic films.

Papers useable as sensor substrates range from tissue to fiberboard. Sensing conductors can be printed onto the paper substrate using various conductive inks and conventional printing processes. Depending on the type of inks and the printing method used, coated paper stock may be required. Paper substrates are potentially very inexpensive and conducive to ripping or tearing, both of which attributes may be advantageous in airbag cover sensor applications.

Constructing a sensor onto or into cloth allows for the creation of a sensor that is malleable after construction and that can retain the look and feel of the cloth used. Such a sensor might be used under the upholstery of an armrest, in a visor, or in the seat itself. In each of these locations the desired touching surface tends to be soft and pliable, such that these locations would not lend themselves to hard sensors (e.g., those constructed on glass or rigid plastic). A variety of natural and synthetic cloths could be used as sensor substrates such as cottons, nylons and blends, all of which may provide different sets of characteristics. Non-woven materials can also be used as cloth substrates for sensors according to the present invention. Non-woven cloths include those made from blown microfibers as well as stitch bonded materials.

The sensing conductors can be printed onto the cloth, or can be woven directly into the cloth, for example using a thin wire or conductive filament. Depending on the cloth used, a dielectric sealant might be needed to ensure that printed conductive inks do not undesirably bleed through the cloth and make contact with a shield layer that may be provided on the back side of the sensor. In some embodiments, two layers of cloth may be used to construct the sensor, each layer including a conductive material. In such a construction one layer could be used as the sensing layer and the other as a shielding layer. A third layer could be used between them as an insulating layer. Cloth sensors could also be embroidered using commercially available embroidery equipment commonly used to create logos on T-shirt and baseball caps. This equipment along with conductive thread could be used to create conductive areas on the cloth and/or wire traces for electrical connection with a wiring harness or control electronics.

A myriad of plastic films can be used as substrates to construct sensors for the present invention, including polyesters, polycarbonates, polyimides, and many others. Each of these materials has vastly different processing capabilities and final sensor attributes. Polyester can be printed with a number of different types of conductive inks to create a sensor, the processes used for printing such inks being commonly known. Likewise, polyimide can be used as a base substrate for printed sensor constructions or as a base material for flex circuit constructions, both being well defined processes.

Because the sensors of the present invention are disposed behind surfaces in a vehicle that are generally opaque, the choice of substrate material is not constrained by optical characteristics, as is often the case with on-display touch sensors. This increases the available substrate materials, which can be chosen for their mechanical or other properties.

A variety of conductive inks are commonly used in the construction of touch sensors. The choice of a suitable ink is a function of the properties of the substrate material as well as the process used to print the ink. Conductive inks such as those available from Acheson Industries under the trade designations 479SS or 461SS are commonly used with polyester substrates, but such inks or similar formulation could also be used with polyimide, cloth, paper, and other substrates to construct conductive areas and traces.

Regardless of the base material used, conductive traces or wires can be disposed to run from the sensing conductors so that the sensor can be connected to the controller electronics. There are a variety of ways to achieve this interconnection. The interconnection can be made using a commercially available connector that is disposed on the substrate. Controller electronics can then be plugged into the connector. Depending on the materials and construction methods used, the interconnect can be made between the traces on the sensor and a flex circuit tail, or from the traces on the sensor directly to the controller electronics.

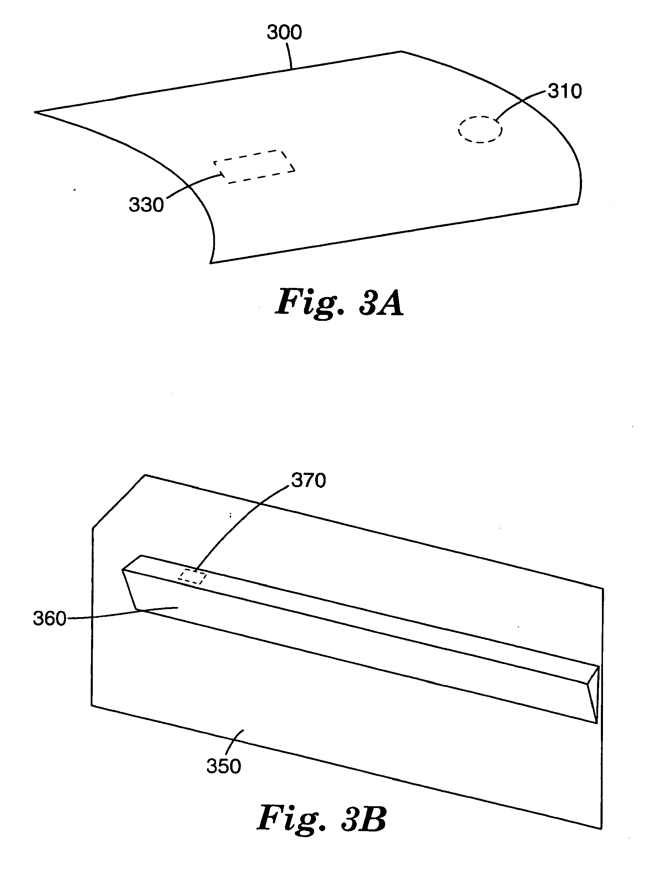

As discussed, touch sensors can be located on the steering wheel or in any other location in a vehicle that is accessible to an occupant. For example, Figure 3A shows a section of a dashboard cover 300 that encloses touch sensors 310 and 330, which are activatable by touching the surface of the dashboard 300 in designated areas. As another example, Figure 3B shows a vehicle door 350 that includes an armrest 360 that incorporates a touch sensor 370 activatable by touching the surface of the armrest in a designated area. Other possible touch sensor locations will be readily apparent from these and other examples described herein.

The present invention contemplates that capacitive touch sensors are located so that they can be activated by touching designated areas of vehicle surfaces that are accessible to vehicle occupants. As such, the touch sensors are generally not visibly apparent, nor are the touch sensors apparent by touch. It may be desirable, then, to mark the designated sensor areas by visible and/or tactile markings or other indicia on the surface covering the touch sensors. For example, graphics, characters, or other symbols can be printed, embossed, molded, decal transferred, or disposed in any other suitable manner on the surface in the designated area. Alternatively or additionally, a relief pattern can be printed, embossed, decal transferred, or disposed in any other suitable manner on the surface in the designated area so that a user can discern from tactile senses whether the designated area is being touched. In embodiments where multiple touch sensors are used, the graphics or tactile patterns can be differentiated for each touch sensor to help the user discern each touch sensor and/or to help the.user understand how to interact with a particular touch sensor. Tactile markings can be positive (raised), negative (indented), or a combination of the two.

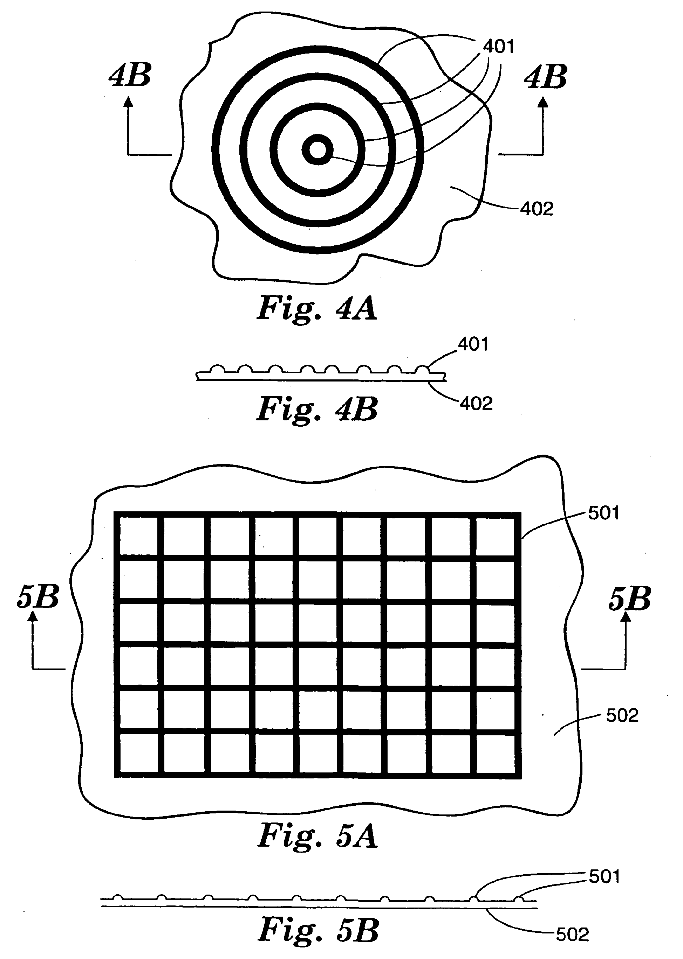

Figure 4A shows a portion of a vehicle surface 402 that covers a discrete button touch sensor (not shown). The designated area for activating the touch sensor is indicated by a raised pattern of concentric circles 401, forming a sort of bull's-eye. Figure 4B shows a side view taken along line B-B of Figure 4A. The raised pattern gives the user tactile feedback to help locate the button sensor. Also, the bull's-eye pattern may intuitively indicate to the user that the sensor is a button sensor. Figure 5A shows a portion of a vehicle surface 502 that covers an x-y sensor pad (not shown). The designated area for interacting with the x-y sensor pad is indicated by a raised pattern of orthogonal lines 501, forming an x-y grid. The raised pattern gives the user tactile feedback to help locate the x-y sensor and to help the user gauge distance as the applied touch is moved across the sensor. Also, the grid pattern may intuitively indicate to the user that the sensor is an x-y sensor.

Sensors can be disposed behind or embedded in surfaces in a vehicle in a number of ways. Sensors constructed on substrates can be laminated or otherwise adhered to the back of the object that forms the surface to be sensed through. Sensors constructed on substrates can be laminated or otherwise adhered or disposed on a surface onto which the object that forms the surface to be sensed through is to be placed. It is also possible to dispose the sensor so that it is integral with the object that forms the surface to be sensed through. For example, when the object is a molded part; the sensor can be molded directly into the object. When the object is a fabric, the sensor can be woven directly into the fabric. It is also possible to use the object that forms the surface to be sensed through as the substrate for the sensor. For example, sensing electronics can be formed onto a decal layer and then transferred from the decal layer to a surface of the object opposing the surface to be sensed through. Publication US 2001/0032698 discloses decal methods that can be used to transfer sensing electronics.

The present invention should not be considered limited to the particular examples described above, but rather should be understood to cover all aspects of the invention as fairly set out in the attached claims. Various modifications, equivalent processes, as well as numerous structures to which the present invention may be applicable will be readily apparent to those of skill in the art to which the present invention is directed upon review of the instant specification.

## Claims

1. A touch input device for interacting with electronic systems in a vehicle that includes an airbag, comprising:
an airbag cover (260) having a surface accessible to and touchable by an occupant of the vehicle; and
a capacitive touch sensor (110; 210, 220, 230, 240) disposed between the airbag and the airbag cover (260), the touch sensor (110; 210, 220, 230, 240) configured so that a touch to a designated area of the surface of the airbag cover (260) allows capacitive coupling between the touch and the touch sensor (110; 210, 220, 230, 240) through the airbag cover (260), the touch sensor (110; 210, 220, 230, 240) adapted for connecting to a controller (120) capable of using signals generated by the capacitive coupling to interact with electronic systems of the vehicle,
**characterized in that** the capacitive touch sensor (110; 210, 220, 230, 240) is configured to safely blow apart upon deployment of the airbag.

2. The touch input device of claim 1, wherein the surface of the airbag cover (260) comprises a relief pattern marking the designated area.

3. The touch input device of claim 1, wherein the airbag cover (260) is on a steering wheel (200).

4. The touch input device of claim 3, wherein the steering wheel (200) incorporates additional touch sensors.

5. The touch input device of claim 1, wherein the capacitive touch sensor (110; 210, 220, 230, 240) comprises a substrate comprising at least one of paper, cloth or plastic.

6. The touch input device of claim 1, wherein the airbag cover (260) provides a substrate for the capacitive touch sensor (110; 210, 220, 230, 240).

7. The touch input device of claim 1, wherein the electronics systems include a heating/cooling/blower system.

8. The touch input device of claim 1, wherein the electronics systems include a navigational system.

9. The touch input device of claim 1, wherein the electronics systems include a hands-free phone.

## Patentansprüche

1. Berührungseingabevorrichtung zum Zusammenwirken mit elektronischen Systemen in einem Fahrzeug, das einen Airbag enthält, umfassend:
eine Airbag-Abdeckung (260) mit einer Fläche, die für einen Insassen des Fahrzeugs zugänglich ist und von ihm berührt werden kann; und
einen kapazitiven Berührungssensor (110; 210, 220, 230, 240), der zwischen dem Airbag und der Airbag-Abdeckung (260) angeordnet ist, wobei der Berührungssensor (110; 210, 220, 230, 240) so konfiguriert ist,
dass eine Berührung eines bestimmten Bereichs der Fläche der Airbag-Abdeckung (260) eine kapazitive Kopplung zwischen der Berührung und dem Berührungssensor (110; 210, 220, 230, 240) durch die Airbag-Abdeckung (260) gestattet, wobei der Berührungssensor (110; 210, 220, 230, 240) zur Verbindung mit einer Steuerung (120) ausgeführt ist, die durch die kapazitive Kopplung erzeugte Signale verwenden kann, um mit elektronischen Systemen des Fahrzeugs zusammenzuwirken,
**dadurch gekennzeichnet, dass** der kapazitive Berührungssensor (110; 210, 220, 230, 240) dazu konfiguriert ist, bei Entfalten des Airbags sicher auseinanderzufliegen.

2. Berührungseingabevorrichtung nach Anspruch 1, wobei die Fläche der Airbag-Abdeckung (260) eine Reliefmustermarkierung des bestimmten Bereichs umfasst.

3. Berührungseingabevorrichtung nach Anspruch 1, wobei sich die Airbag-Abdeckung (260) an einem Lenkrad (200) befindet.

4. Berührungseingabevorrichtung nach Anspruch 3, wobei das Lenkrad (200) zusätzliche Berührungssensoren enthält.

5. Berührungseingabevorrichtung nach Anspruch 1, wobei der kapazitive Berührungssensor (110; 210, 220, 230, 240) ein Substrat umfasst, das Papier und/oder Stoff und/oder Kunststoff umfasst.

6. Berührungseingabevorrichtung nach Anspruch 1, wobei die Airbag-Abdeckung (260) ein Substrat für den kapazitiven Berührungssensor (110; 210, 220, 230, 240) bereitstellt.

7. Berührungseingabevorrichtung nach Anspruch 1, wobei die elektronischen Systeme ein Heiz-/Kühl-/Gebläsesystem enthalten.

8. Berührungseingabevorrichtung nach Anspruch 1, wobei die elektronischen Systeme ein Navigationssystem enthalten.

9. Berührungseingabevorrichtung nach Anspruch 1, wobei die elektronischen Systeme ein Telefon mit Freisprecheinrichtung enthalten.

## Revendications

1. Dispositif d'entrée tactile pour interagir avec des systèmes électroniques dans un véhicule qui comprend un coussin gonflable, comprenant :
un couvercle de coussin gonflable (260) ayant une surface accessible à l'occupant du véhicule et pouvant être touché par celui-ci ; et
un capteur tactile capacitif (110 ; 210, 220, 230, 240) disposé entre le cousin gonflable et le couvercle du cousin gonflable, ce capteur tactile (110 ; 210, 220, 230, 240) étant configuré de façon à ce qu'un contact avec une zone désignée de la surface du couvercle du coussin gonflable (260) permette un couplage capacitif entre le contact et le capteur tactile (110 ; 210, 220, 230, 240) par l'intermédiaire du couvercle du coussin gonflable (260), le capteur tactile (110 ; 210, 220, 230, 240) étant conçu pour se connecter à un dispositif de commande (120) capable d'utiliser des signaux générés par le couplage capacitif afin d'interagir avec les systèmes électroniques du véhicule,
**caractérisé en ce que** le capteur tactile capacitif (110 ; 210, 220, 230, 240) est configuré de façon se séparer brusquement de manière sûre lors du déploiement du coussin gonflable.

2. Dispositif d'entrée tactile selon la revendication 1, dans lequel la surface du couvercle du coussin gonflable (260) comprend un motif en relief marquant la zone désignée.

3. Dispositif d'entrée tactile selon la revendication 1, dans lequel le couvercle du coussin gonflable (260) est sur un volant (200).

4. Dispositif d'entrée tactile selon la revendication 3, dans lequel le volant (200) incorpore des capteurs tactiles supplémentaires.

5. Dispositif d'entrée tactile selon la revendication 1, dans lequel le capteur tactile capacitif (110 ; 210, 220, 230, 240) comprend un substrat constitué par au moins soit du papier, soit du tissu, soit du plastique.

6. Dispositif d'entrée tactile selon la revendication 1, dans lequel le couvercle du coussin gonflable (260) fournit un substrat pour le capteur tactile capacitif (110 ; 210, 220, 230, 240).

7. Dispositif d'entrée tactile selon la revendication 1, dans lequel les systèmes électroniques comprennent un système de chauffage/refroidissement/ventilation.

8. Dispositif d'entrée tactile selon la revendication 1, dans lequel les systèmes électroniques comprennent un système de navigation.

9. Dispositif d'entrée tactile selon la revendication 1, dans lequel les systèmes électroniques comprennent un téléphone mains libres.
